# EUROPEAN PATENT SPECIFICATION

(11) **EP 1 341 299 B1**
(45) Date of publication and mention of the grant of the patent: **13.05.2009**
(21) Application number: 02004486.3
(22) Date of filing: 27.02.2002
(51) Int. Cl.: H03F 1/02

(54) **Power detection in an amplification device**
Erfassung von RF-Leistung einer Verstärkervorrichtung
Détection de puissance d'un dispositif d'amplification

(43) Date of publication of application: 03.09.2003
(73) Proprietor: TDK Corporation, Chuo-ku, Tokyo (JP)
(72) Inventor: Humphrey, Denver Edward Johnston, County Antrim, Northern Ireland BT43 7HD (GB)
(74) Representative: Wallace, Alan Hutchinson

(56) References cited:
- WO-A-01/56176
- US-A- 5 559 471
- US-A- 5 757 237
- US-A- 6 130 579

## Description

### FIELD OF THE INVENTION

The present invention relates to power detection in amplification devices. The invention is particularly concerned with power detection in a gain controlled multi-stage amplification device.

### BACKGROUND TO THE INVENTION

In many applications, it is necessary to measure, or detect, the output signal power level of an amplification device. For example, gain controlled amplifiers are often associated with a gain control loop wherein it is necessary to measure the output power of the amplification device in order to determine how the gain of the device should be adjusted in order that the output power meets a desired reference level. By way of example, single-band or multi-band transmitters, as used for example in mobile telecommunications equipment, commonly comprise single-band or multi-band amplifiers with gain control loops.

Conventionally, measurement of the output power level of an amplification device is achieved by placing a coupling device in the output path of the device. This is considered to be undesirable as, amongst other things, it complicates the matching requirements of the amplification device. It is also known to measure output power by measuring the amount of current drawn from the amplification device's power supply by means of the voltage drop across a resistor in the supply. This is also considered to be undesirable as it reduces the overall amount of voltage available to the amplifier.

US 5 757 237, US 5 559 471, US 6 130 579, and WO 01/56176 disclose various power detection and biasing circuits for RF power amplifiers.

The present invention concerns improvements in output power detection of an amplification device.

While the present invention is described herein particularly in connection with single-band and multi-band amplifiers for mobile telephones, it will be appreciated that the invention is not limited to use with such.

### SUMMARY OF THE INVENTION

The invention provides an amplification device (5) arranged to receive an input signal and to amplify the received input signal to produce a first output signal, the amplification device comprising at least two amplification stages, each amplification stage including a respective amplifier (7, 7', 7") having a respective bias control input (9, 9', 9"), **characterized in that** the amplification device further includes a diode (27) having its anode coupled to the bias control input (9') of the respective amplifier (7') of one of said amplification stages, and its cathode coupled to ground (31); a capacitor (35) connected in series with the diode and ground; and an adder device (200, 300) arranged to sum, in use, a respective bias control signal received at the bias control input (9') of said respective amplifier (7') with a diode signal derived from the cathode of said diode, to produce a second output signal that is indicative of the power of the first output signal.

Other advantageous aspects of the invention will become apparent to those ordinarily skilled in the art upon review of the following description of specific embodiments of the invention and with reference to the accompanying drawings.

### BRIEF DESCRIPTION OF THE DRAWINGS

Embodiments of the invention are now described by way of example and with reference to the accompanying drawings in which:
Figure 1 is a block diagram of a power amplifier;
Figure 2 is a schematic view of an amplification device including power detector circuitry in accordance with a preferred embodiment of the invention;
Figure 3 is a schematic view of an adder device.
Figure 4 is a schematic view of an adder device and gain controller circuit for use with the power detector circuitry of Figure 2; and
Figure 5 is a schematic view of the transmit path as may be found in a cellular telephone;
Figure 6 is a block diagram of a conventional dual-band transmitter included in the transmit path of Figure 5;
Figure 7 is a block diagram of a preferred amplifying apparatus including an amplification device with power detector circuitry in accordance with the invention;
Figure 8a is a graph showing output power of the amplification device against the base voltage of an amplifier within the device;
Figure 8b is a graph showing output power of the amplification device against a diode voltage within the detector circuitry;
Figure 8c is a graph showing output power of the amplification device against voltage detected by the detector circuitry; and
Figure 9 is a schematic view of an amplification device including power detector circuitry in accordance with an alternative embodiment of the invention.

### DETAILED DESCRIPTION OF THE DRAWINGS

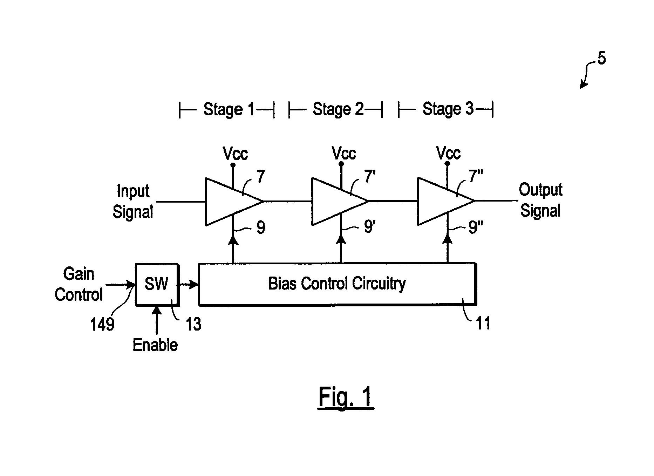

Referring now to Figure 1, there is shown a block diagram of an amplification device in the form of a power amplifier 5. The power amplifier 5 comprises a cascade or chain of amplification stages (preferably a chain of three stages, annotated as *stage 1, stage 2* and *stage 3* in Figure 1) each stage comprising a respective amplifier 7, 7', 7" in the form of, for example, a heterojunction bipolar junction transistor (HBT) in, for example, Silicon Germanium (SiGe) or Gallium Arsenide (GaAs) technology. Each amplifier 7, 7', 7" is connected to a supply voltage Vcc in conventional manner. The amplifiers 7, 7', 7" also have a respective gain, or bias, control input 9, 9', 9" which, in the case where the amplifiers 7, 7', 7" comprise bipolar transistors, may be provided by the base input of the respective transistor. It will be understood that the amplifiers 7, 7', 7" are not necessarily identical and normally have different amplifying characteristics, as is conventional in a multi-stage amplifying chain. The power amplifier 5 further includes conventional bias control circuitry 11 for controlling the respective gain of the amplifiers 7, 7', 7" by supplying a bias control signal which, in the present example, involves adjusting the respective base, or bias, voltages of the amplifiers 7, 7', 7'' via the base inputs 9, 9', 9''.

The amplifier chain and the bias control circuitry 11 are of generally conventional design. Additional conventional circuitry such as input, output and inter-stage matching networks are not shown in Figure 1 for reasons of clarity. As is conventional, a gain control signal is supplied directly to the bias control circuitry 11 in accordance with which the bias control circuitry 11 adjusts the individual gains of the amplifiers 7, 7', 7" thereby adjusting the gain of the overall power amplifier 5.

In many applications, it is necessary to measure the power of the output signal from the power amplifier 5. For example, where the power amplifier is associated with a gain control loop (not shown in Figure 1), the output signal power level of the power amplifier is measured (typically in terms of voltage) and compared with a reference signal (typically in terms of a voltage versus time profile) which corresponds with the required power level of the output signal. A controller (not shown in Figure 1) then generates a gain control signal depending on the difference between the measured value of output signal power and the corresponding value of the reference signal. Conventionally, the output power level of the power amplifier 5 is measured by a detector (not shown in Figure 1) comprising a coupling device, such as an RF coupler. However, such detectors are considered to be undesirable for the following main reasons: they are normally only able to operate over a limited bandwidth; and their presence in the output transmission line of the power amplifier means that power detection is non-passive and this complicates, for example, the matching considerations for the amplifier.

It is also known to measure the output power from a power amplifier by measuring the current drawn from its power supply (Vcc) since it is known that, as output power increases, the current drawn by the power amplifier also increases. To do this, a resistor (not shown) is placed between the power supply and the power amplifier. The voltage drop across the resistor is measured to determine the drawn current. This voltage measurement is therefore indicative of the output power of the power amplifier. However, the presence of the resistor reduces the voltage available to the power amplifier and so compromises the efficiency of the power amplifier.

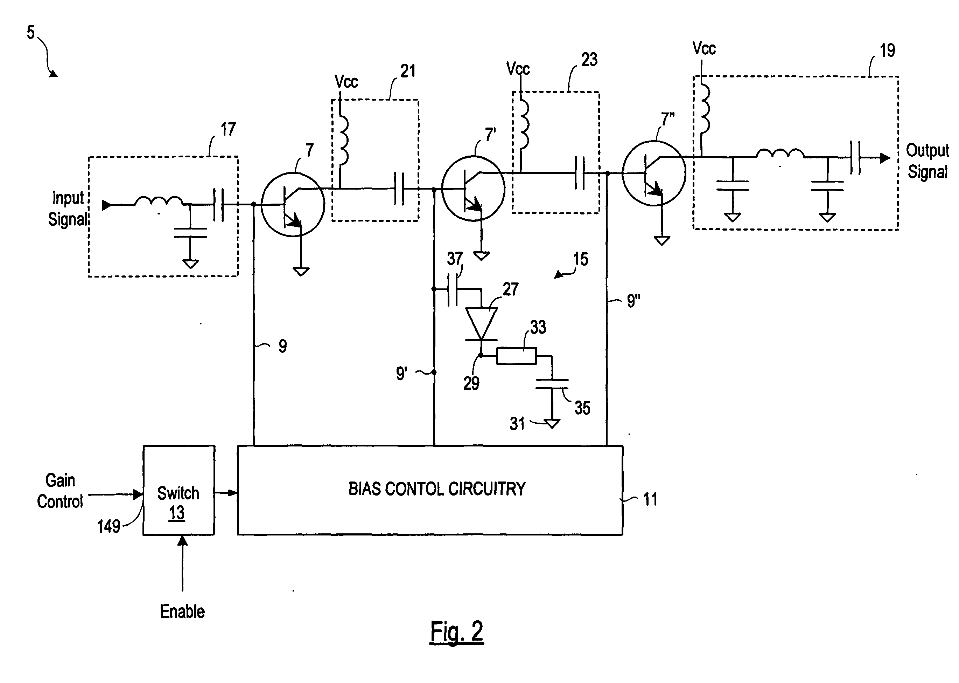

Figure 2 illustrates the power amplifier 5 in more detail and also shows circuitry, generally indicated at 15, for use in measuring, or detecting, the power of the output signal of the power amplifier 5. The detector circuitry, hereinafter referred to as detector 15, is provided and arranged in accordance with a preferred embodiment of the invention. The depiction of the power amplifier 5 in Figure 2 is generally similar to that shown in Figure 1. In Figure 2, however, an input matching network 17, an output matching network 19 and two inter-stage matching networks 21, 23 are shown. The specific topography of network elements (e.g. capacitors and inductances) in the matching networks 17, 19, 21, 23 shown in Figure 2 is given by way of example only and is not limiting to the invention. The respective amplifier 7, 7', 7" of each amplifying stage is shown as a transistor, each having a respective base input 9, 9', 9'' (bias control input) connected to the bias control circuitry 11. The power amplifier 5 may be referred to as a gain controlled amplification device because, for a given input power level, the output power level of the power amplifier 5 is determined by a gain control signal applied to a gain control input 149 (which in turn is used to determine, via the bias control circuitry 11, the respective bias control signals, or base voltages, of the amplifiers 7, 7', 7" within the power amplifier 5).

In its simplest form, the invention involves measuring the bias control signal (which for a bipolar transistor comprises the base voltage) applied to one of the amplifiers 7, 7', 7" and using the measured value as an indication of the output signal power level of the power amplifier 5. In such an embodiment, the detector in its simplest form requires only an electrical connection between the base input 9, 9', 9'' of one of the amplifiers 7, 7', 7" and an input of a gain controller although, if supplying the bias control signal to a controller comprising a comparator, a current limiting resistor (not shown) may be required between the base input 9, 9', 9" and the comparator.

In the preferred embodiment, however, the detector 15 includes a diode 27 having its positive terminal (anode) coupled or connected to the base input 9, 9', 9'' of an amplifier 7, 7', 7" (the mid-stage amplifier 7' is preferred - see Figure 2), and its negative terminal (cathode) coupled to ground 31. A resistor 33 and a capacitor 35 are connected in series between the diode 27 and ground 31. This type of diode circuit is sometimes referred to as a peak detector. Preferably, a further capacitor 37 is provided between the anode of the diode 27 and the base input 9'.

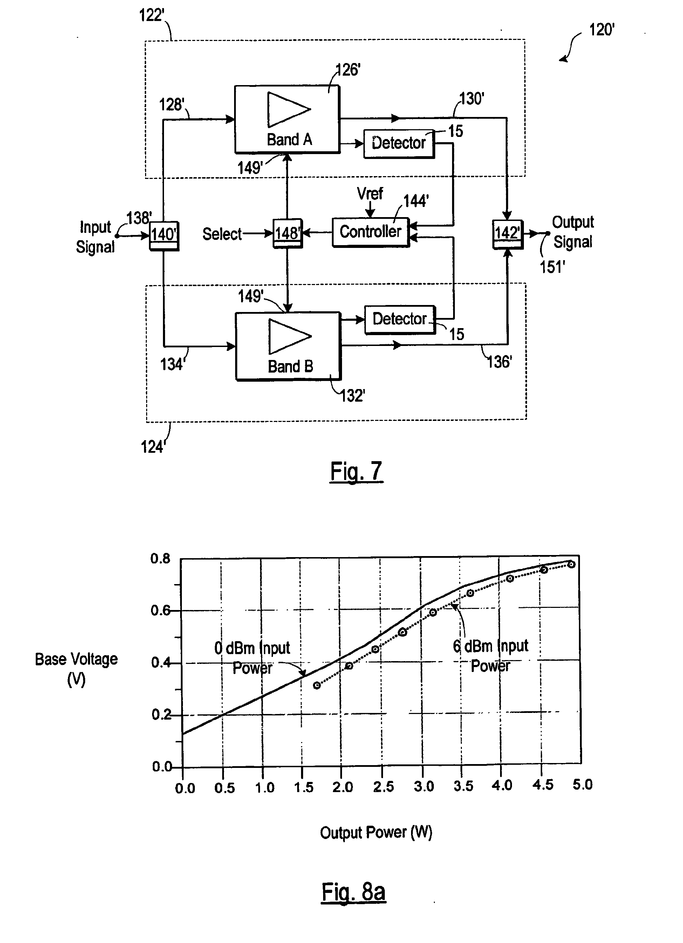

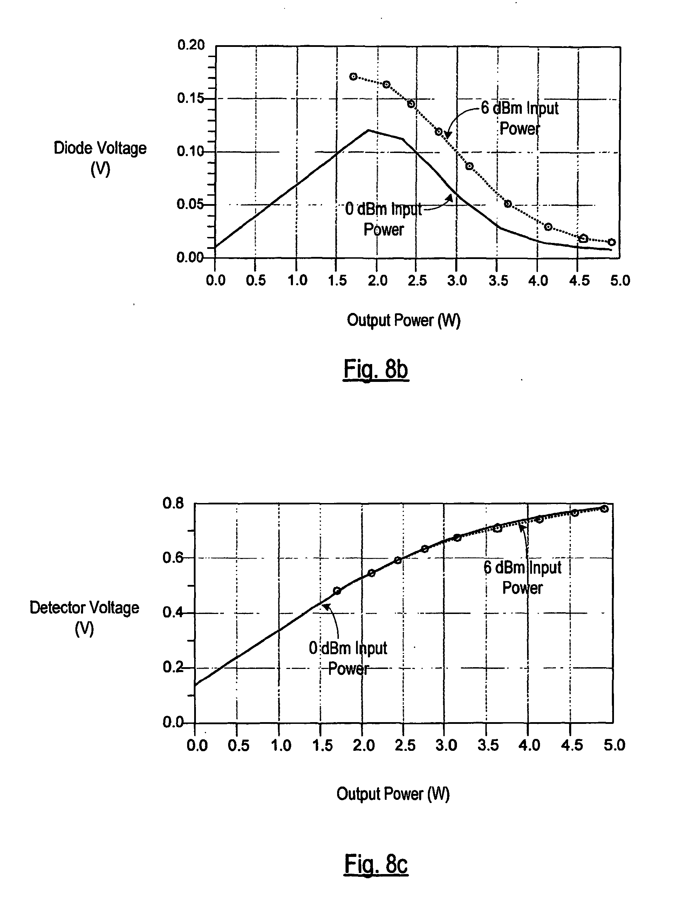

In this embodiment, the measured, or detected, voltage is the sum of the voltage at node 29 (referred to as the diode voltage) and the base (or bias) voltage measured at the base input 9'. If the base voltage is used solely as the measured voltage for indicating output signal power level, then an incorrect indication of power level will be obtained if the power of the power amplifier input signal increases. The presence of the diode 27 and the summation of voltages in the manner described above allows the detector 15 to operate accurately independently of input signal power levels. By way of example, Figure 8a shows a plot of the base voltage level at point 9' (vertical axis) against absolute output signal power (horizontal axis) when the input signal power to the power amplifier 5 is 0 dBm (solid line) and 6 dBm (dashed line). It will be seen that, for a given absolute output signal power level, the voltage level at 9' differs depending on the input signal power level. This is undesirable since any apparatus using solely the voltage level at 9' as an indication of output signal power would require recalibration for different input signal power levels. Figure 8b shows a plot of the diode voltage at node 29 (vertical axis) against absolute output signal power (horizontal axis) when the input signal power to the power amplifier 5 is 0 dBm (solid line) and 6 dBm (dashed line). Again, for a given absolute output power level, the diode voltage at 29 differs depending on the input power level. Figure 8c illustrates detected voltage level (vertical axis) against absolute output power (horizontal axis) when the input power to the power amplifier 5 is 0 dBm (solid line) and 6 dBm (dashed line), where the detected voltage is the summation of the voltages at nodes 9' and 29. It will be seen that the 0 dBm plot and the 6 dBm plots are substantially coincident, and each detected voltage level has a one-to-one correspondence with a respective output signal power level.

In order that the detector 15 may operate correctly, the base voltage should be greater than the transistor 7' turn-on voltage, which typically is approximately 0.6 volts for SiGe devices.

The diode 27 serves to convert RF current/voltage into d.c. current voltage. The capacitor 35 serves as a d.c. block and ensures that only RF signals contribute to the voltage at 29. This means that the application of the bias control signal (which is d.c.) to the base input 9' of the transistor 7' is unaffected by the presence of the diode 27, resistor 33 and capacitor 35. The capacitor 37 serves to prevent d.c. bias from affecting the characteristics of the diode 27 as the power amplifier 5 is turned on. The resistor 33 is provided to present a large impedance and to facilitate voltage measurement by increasing the diode voltage at point 29. Thus, the value of the resistor 33 is selected to ensure that only a relatively insignificant portion of the RF signal applied to the base input 9' of the transistor 7' is applied to the diode 27 circuit while ensuring that an adequate voltage is created at point 29 for measurement. Hence, the performance of the power amplifier 5 is substantially unaffected by the presence of the detector 15. By way of example, the resistor 33 may take the value of approximately 500kΩ and the capacitors 35, 37 may take the value of approximately 30pF to 100pF - in the preferred embodiment, capacitor 35 takes the value of approximately 100pF while capacitor 37 takes the value of approximately 30pF. In use, if the power of the RF input signal increases, then the RF voltage applied to the detector circuit also increases, giving rise to an increased RF current through the resistor 33. This increase can be measured as a corresponding increase in d.c. voltage at point 29 i.e. the voltage developed across the resistor 33. Similarly, if the power of the RF input signal decreases, the d.c. voltage at point 29 decreases by a corresponding amount. Thus, by summing the voltage signal at 29 with the bias control voltage at 9', the resultant detected output power signal increases and decreases in accordance with the input power level and so serves as an accurate indicator of actual output signal power.

It will be understood that it is not essential to measure the diode voltage from point 29. In an alternative embodiment, the detected output power signal may be derived by summing the bias control voltage at 9' with the voltage between resistor 33 and capacitor 35. Alternatively still, the resistor 33 may be replaced with a network of two or more resistors in series and/or parallel. In this case the detected output power signal may be derived by summing the bias control voltage at 9' with a voltage from before, after or within the resistor network. In such alternative embodiments, the device (not shown) e.g. gain controller that uses the detected output power signal would need to be calibrated appropriately.

It is preferred to use the detector 15 in conjunction with an intermediate stage of a multi-stage power amplifier rather than the first stage or the last stage. This is because, with the first stage, inaccurate measurements may arise due to increases in input power having a disproportional effect on the base voltage of the first stage amplifier 7, while for the final stage, inaccurate measurements may arise since the base voltage of this stage tends to remain constant as output signal power increases close to its maximum level. In the preferred three stage power amplifier 5 the detector 15 is connected to the second stage of the power amplifier 5.

The detector 15 may be provided internally or externally of any IC package, e.g. MMIC (monolithic microwave integrated circuit), containing the power amplifier circuitry, as is convenient. In the preferred embodiment, at least the diode 27 and optionally also the resistor 33 and capacitors 35, 37 (hereinafter "the diode circuit") are included in an IC that contains the conventional power amplifier circuitry. The resulting IC package (not shown) comprises a first output terminal, or pin, for providing the main RF output signal (i.e. the amplified RF input signal), a second terminal for providing a second output signal in the form of the bias control signal (in this case the base voltage taken from the base input 9'), and a third output terminal for providing a third output signal in the form of the diode voltage from node 29. The output signals from the second and third output pins are then summed "off-chip" using an adding device as is described in more detail below. In an alternative embodiment, the adder device is also provided in the IC package and arranged to sum the base voltage (at 9') and the diode voltage (at 29) to produce a second output signal (which in this case comprises the detected power signal) which is provided at a second output pin of the IC package. In a still further embodiment, the diode circuit and the adder device are each provided "off-chip" and so the IC package containing the amplification device need only provide a second output signal, at a second output pin, in the form of the bias control signal (in this case the base voltage from the base control input 9').

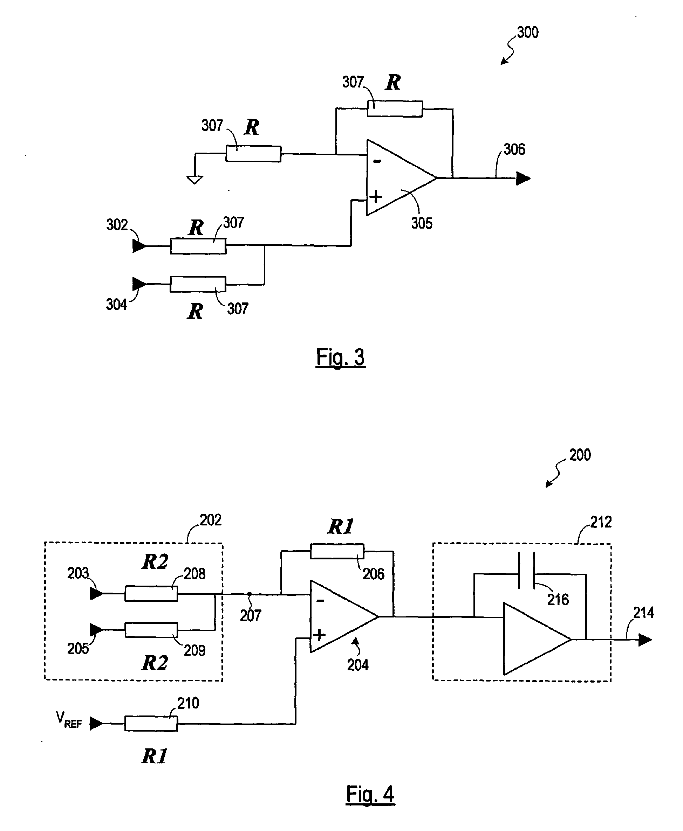

Figure 3 shows, by way of example only, a suitable adder device, or circuit 300 comprising two inputs 302, 304, a differential amplifier 305 and resistors 307 (which need not necessarily take the same value R). The adder circuit 300 combines voltage signals at inputs 302, 304 to produce a summed output signal at 306. In use, the signals to be summed, namely the voltages at 9' and 29 of Figure 2, are provided to a respective input 302, 304 and the resulting output signal at 306 (which corresponds to the detected output power signal) may be supplied to whatever further device (not shown) that requires the detected power signal. For example, in a gain controlled amplification device, the detected power signal at 306 may be supplied to a conventional comparator circuit (not shown in Fig. 3) for comparison with a reference signal in order to generate a gain control signal.

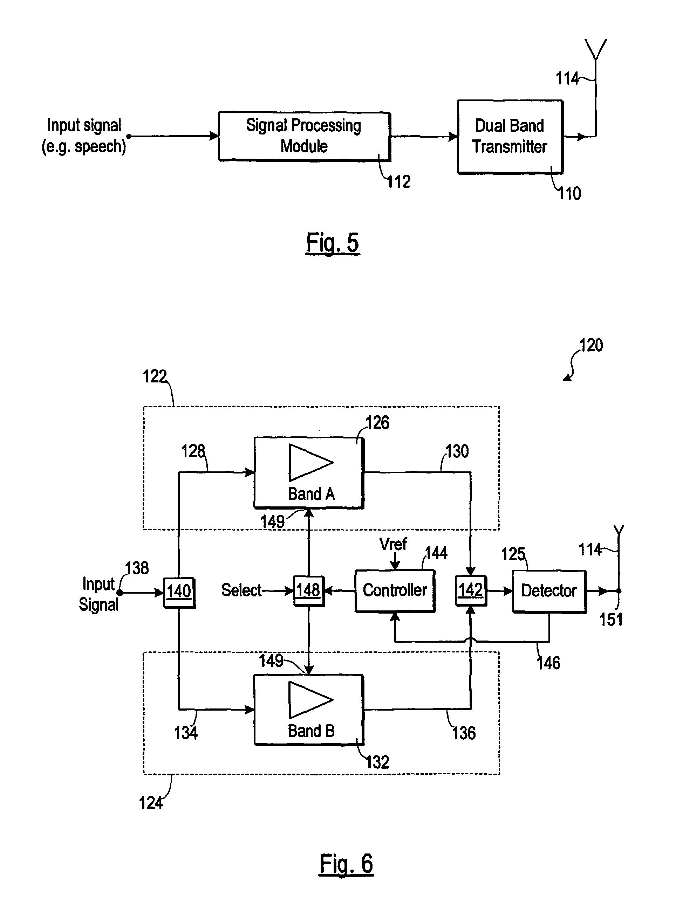

It is now described, by way of example and with reference to Figures 5 to 7, how the power amplifier 5, with detector 15, may be used in the context of a gain control loop. Figures 5 to 7 relate particularly to a dual-band amplifying apparatus although it will be understood that the amplification device and detector of the invention are not limited to use with such and may equally be used with single-band or multi-band amplifying apparatus.

Referring now to Figure 5 of the drawings, there is shown in schematic view the transmit path of a wireless communication apparatus such as a mobile, or cellular, telephone (not shown). In the following description, the communication apparatus is assumed to be a dual-band cellular telephone although it will be understood that the invention is not limited to such. The transmit path includes a dual-band transmitter 110 and a signal processing module 112. The signal processing module 112 is arranged to receive an input signal comprising the information or data to be transmitted from the cellular telephone. The input signal typically comprises a speech signal from a microphone (not shown) or a signal generated from a text message. The signal processing module 112 is arranged to perform conventional signal processing operations, such as speech encoding, channel encoding and carrier signal modulation, on the received input signal. To this end, the signal processing module 112 typically includes, or is associated with, a respective signal source (not shown) for providing a respective carrier signal in each of the operational frequency bands. Typically, the signal sources comprise voltage controlled oscillators (VCOs) such as RF (Radio Frequency) sources providing RF carrier signals in, for example, the GSM (Global System for Mobile Telecommunications ≈ 900MHz) or DCS (Digital Communications System ≈ 1800MHz) bands, although it will be appreciated that the carrier signals may alternatively be in other RF or non-RF frequency bands. The signal processing module 112 then provides the processed signal as an input to the dual-band transmitter 110. In the present example, the signal processing module 112 supplies to the dual-band transmitter 110 an RF signal comprising a carrier signal, in either the GSM or DCS bands, modulated with voice data.

The main purpose of the transmitter 110 is to amplify the processed signal and to supply the amplified signal to an antenna 114 whereupon it is emitted as a radio signal (assuming an RF carrier). The transmitter 110 and the signal processing module 112 are normally provided on the motherboard (not shown) of the cellular phone.

It will be appreciated that Figure 5 and the accompanying description provide a simplistic overview of the transmit path and its components. Further detail, being conventional and not required for understanding the present invention, has been omitted for reasons of clarity.

Figure 6 is a simplified block diagram of a conventional dual-band transmitter of which is shown an amplifying apparatus 120 connected to the antenna 114. The amplifying apparatus 120 is a dual-band amplifier comprising first and second amplifying sections 122, 124 and a conventional detector 125. The first amplifying section 122 comprises an amplification device, typically in the form of a power amplifier 126, an input transmission line 128, and an output transmission line 130. Similarly, the second amplifying section 124 comprises a power amplifier 132, an input transmission line 134 and an output transmission line 136. Each power amplifier 126, 132 is arranged to amplify signals in a respective frequency band *Band A, Band B* which, by way of example, may comprise the GSM and DCS frequency bands.

The input transmission lines 128, 134 are arranged to carry input signals to the respective power amplifier 126, 132 from the input of the amplifying apparatus 120. Since input signals are received via a single input port 138, a switch 140 is provided at the input port 138. The switch 140 is controlled in conventional manner so that input signals in *Band A* are directed to the first power amplifier 126 via transmission line 128, while input signals in *Band B* are directed to the second power amplifier 132 via transmission line 134. Thus, the switch 140 supplies an input signal to only one of the power amplifiers 132, 126 - the "active" power amplifier - at a time, depending on the frequency of the input signal, the other power amplifier 126, 132 being "inactive". The switch 140 has the intended effect of isolating one amplifying section 122, 124 from the other in order to ensure that a signal intended for one power amplifier 126, 132 does not travel along the transmission line 128, 134 leading to the other power amplifier 126, 132.

The output transmission lines 130, 136 are arranged to carry output signals from the respective power amplifier 126, 132 to a diplexer 142. The diplexer 142 is arranged in conventional manner to supply the output of the active power amplifier to an output port 151 of the amplifying apparatus 120 via the detector 125. The output signal is then supplied to the antenna 114 which is arranged to emit signals in *Band A* or *Band B.* The diplexer 142 prevents the output signal from the active power amplifier being fed to the output of the inactive power amplifier and prevents the inactive amplification section from interfering with the impedance matching of the active amplifying section.

The detector 125 forms part of a gain control loop for ensuring that the power level of the output signal conforms with desired output power levels. The detector 125 comprises a conventional current or voltage coupling device, such as an RF coupler comprising two adjacent microstrips, that produces a detected output signal (on line 146 in Figure 6) that is proportional to the power of the first output signal being supplied to the output port 151. Conveniently, the second output signal is provided via a diode (not shown) and so takes the form of a voltage signal. The control loop also includes a controller 144 arranged to receive the second output signal from the detector 125 and to compare (using for example a differential amplifier (not shown)) same with a reference signal - in this case a reference voltage *Vref* - which represents the desired output power level. The controller 144 generates a control signal depending on the discrepancy between the reference voltage *Vref* and the voltage received from the detector 125. The control loop further includes a switch 148 arranged to direct, under the control of signal *select,* the control signal to the gain control input 149 of the active power amplifier 126 or 132. The control signal adjusts the gain of the active amplifier 126 or 132 and hence the power of the output signal from the active amplifier. The control process is usually continual and aims to eliminate or minimise the discrepancy between the second output of the detector 125 and the reference voltage *Vref.*

Amplifying apparatus of the general type shown in Figure 6 are commonly known as gain controlled dual-band amplifiers. The detector 125 may alternatively be replaced by two similar detectors, one in each transmission line 130, 136. In either event, it is considered that the detector 125, or detectors, is undesirable since its/their presence in the output transmission line of the power amplifier means that power detection is non-passive and this complicates, for example, the matching considerations for the amplifier.

Further, the conventional RF coupler type detectors are normally only able to operate over a limited bandwidth.

Figure 7 shows in schematic view an amplifying apparatus 120' which is generally similar to the apparatus 120 shown in Figure 6 and in which like reference numerals are used to indicate like parts. Each amplifying section 122', 124' is associated with a respective detector 15 for measuring the output signal power of the respective power amplifier 126', 132' as described above with reference to Figure 6. In accordance with the invention, each detector 15 measures one or more voltages within the respective power amplifier 126', 132' and uses the measured value(s) as an indication of output signal power level. In the preferred embodiment, each detector 15 is arranged to measure the base voltage (at 9', Fig. 2) of the mid-stage amplifier 7' of the respective power amplifier 126', 132' and to sum the measured base voltage with the diode voltage at 29. The output of each detector 15, comprising the detected output signal power, is supplied to the controller 144' for comparison with a reference signal *Vref* in order to generate a gain control signal. It will be noted from Figure 7 that the detectors 15 do not interfere with the respective output transmission lines 130', 136' of the power amplifiers 126', 132'.

Figure 4 shows a circuit 200 comprising an adding device 202 and a gain controller comprising a differential amplifier 204 with resistor 206 of value R1. The signals to be summed, namely the voltages at nodes 9' and 29 (Figure 2), are supplied to a respective input 203, 205 of the adder 202. Each input 203, 205 is associated with a respective resistor 208, 209 of value R2, the respective outputs of the resistors 208, 209 being connected together to provide a summed output signal at node 207 which comprises the detected power signal. The added signal at 207 is supplied to one input of the differential amplifier 204. The other input of the differential amplifier 204 is supplied with the reference signal *Vref* via a resistor 210 of value R1. The differential amplifier 204 compares the detected power signal at 207 with the reference signal *Vref* and supplies an output signal, depending on the difference between the two input signals, to an integrator 212. The integrator 212 produces an output signal at 214, in the form of an error voltage signal, which is proportional to the difference between the detected power signal and the reference signal *Vref.* The signal *Vref* corresponds to the required power level verses time profile and as a consequence this is compared to the detected emitted power level verses time profile. The resistor values R1 and R2 are chosen to enable the detected power signal to be amplified where the gain is proportional to the ratio of R1 / R2. Therefore the voltage levels from each node can be amplified individually and independently (if required).

The time constant of the integrator 212 is determined by the value of the capacitor 216 and thus the output signal at 214 corresponds to the accumulated difference between the detected voltage and *Vref.* It is noted that circuit 200 differs from a conventional gain controller (not shown) by virtue of the additional input 205 and associated resistor 209, which allows circuit 200 to add voltages at inputs 203 and 205 before comparison to *Vref.* Thus, the detected voltage (in this case being the sum of voltages at 203 and 205) is produced without the need for additional diode biasing and coupling.

Referring again to Figure 7, each detector 15 comprises a respective diode circuit (as described with reference to Fig. 2) and a respective adder circuit 202. The output of the detector 15 corresponds with node 207 of Figure 4. As indicated above, the detectors 15 may be incorporated in whole or in part with the respective power amplifier 126', 132', or may be provided separately. The differential amplifier 204 and integrator 212 arrangement shown in Figure 4 is suitable for use as the controller 144' shown in Figure 7, in which case the output provided at 214 serves as the gain control signal (e.g. for supplying the gain control input 149).

The adder circuit 202 shown in Figure 4 assumes that the controller 144' receives input signals in respect of only one power amplifier (e.g. when used in the context of a single-band gain controlled amplifying apparatus (not illustrated). However, the arrangement of Figure 4 may readily be adapted for use in multi-band apparatus, e.g. a dual-band cellular telephone, or similar apparatus, simply by adding more inputs to the adder circuit 202. Since the inactive power amplifier (not shown) will not contribute any detected voltage signals (being disabled), this will not affect the overall operation of the adder circuit 202.

The advantages of the preferred detector 15, and therefore of the power amplifier 5 incorporating the detector 15, include that voltage/power detection is independent of input signal power and signal frequency, is passive and, since there is no current draw, the efficiency of the power amplifier 5 is not compromised. Also, since the detector does not require any coupling with the output transmission line 130', 136', there is no loss of output power due to coupling effects. Further, the power amplifier matching circuitry requires only components for impedance matching and not for power detection thus simplifying the output matching circuits. Also, the limited bandwidth of the coupled line sections is not an issue - the detected voltage/power is valid over the entire bandwidth of the power amplifier 5.

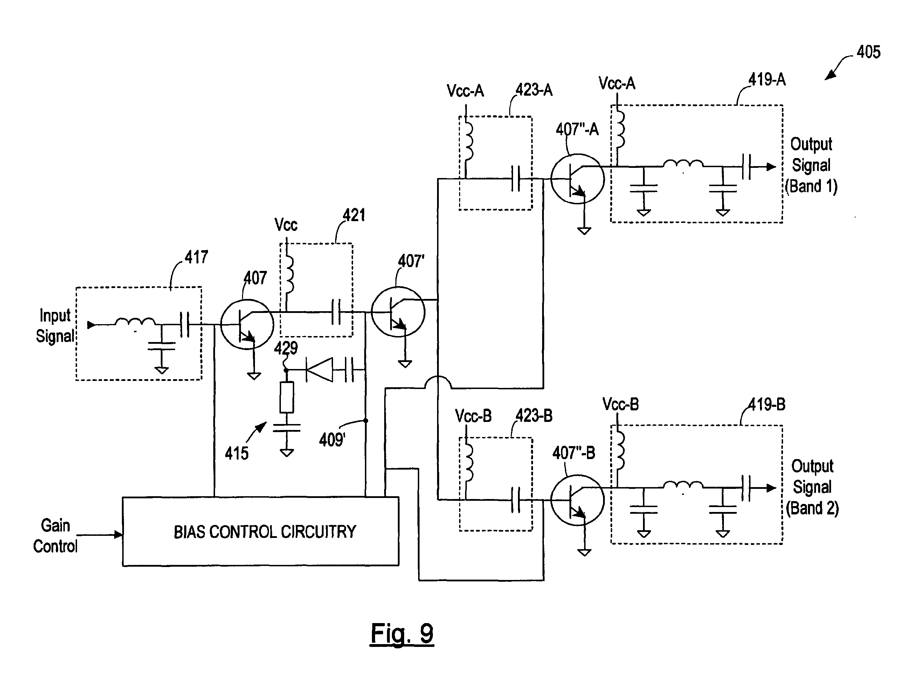

The invention is not limited to use with single band multi-stage power amplifiers of the type shown in Figure 2. Figure 9 shows an alternative embodiment of an amplification device, generally indicated at 405, in the form of a dual-band multi-stage power amplifier. The power amplifier 405 is generally similar in construction to the power amplifier 5 of Figure 2 and like numerals are used to indicate like parts. However, the power amplifier 405 includes two 'third' amplifying stages, each having a respective amplifier 407''-A, 407''-B, respective inter-stage matching network 423-A, 423-B, respective power supply Vcc-A, Vcc-B, and respective output matching network 419-A, 419-B. The respective components of each 'third' amplifying stage are selected in conventional manner for the amplification of signals in respective frequency bands Band 1, Band 2. The power amplifier 405 includes detector circuitry, generally indicated at 415, in accordance with the invention. As described for the Figure 2 embodiment, the detected output signal power may be derived by summing the voltages at points 409' and 429. The detector circuitry 415 may be used with an appropriately calibrated device such as a gain controller (not shown) in a manner similar to that described above with reference to Figure 2.

An amplification device or amplification apparatus arranged in accordance with the invention may be implemented in a number of conventional ways, for example as one or more integrated circuits and/or other conventional electronic components mounted on a substrate, preferably a multi-layer substrate. Alternatively, the apparatus, or a part thereof, may be described, or defined, using a hardware description language (HDL) such as VHDL, Verilog HDL or a targeted netlist format (e.g. xnf, EDIF or the like) recorded in an electronic file, or computer useable file.

Thus, the invention further provides a computer program, or computer program product, comprising program instructions, or computer usable instructions, arranged to generate, in whole or in part, an amplification device according to the invention. The invention may therefore be implemented as a set of suitable such computer programs. Typically, the computer program comprises computer usable statements or instructions written in a hardware description, or definition, language (HDL) such as VHDL, Verilog HDL or a targeted netlist format (e.g. xnf, EDIF or the like) and recorded in an electronic or computer usable file which, when synthesised on appropriate hardware synthesis tools, generates semiconductor chip data, such as mask definitions or other chip design information, for generating a semiconductor chip. The invention also provides said computer program stored on a computer useable medium. The invention further provides semiconductor chip data, stored on a computer usable medium, arranged to generate, in whole or in part, a device according to the invention.

The invention is not limited to the embodiments described herein which may be modified or varied without departing from the scope of the invention.

## Claims

1. An amplification device (5) arranged to receive an input signal and to amplify the received input signal to produce a first output signal, the amplification device comprising at least two amplification stages, each amplification stage including a respective amplifier (7, 7', 7") having a respective bias control input (9, 9', 9"), **characterized in that** the amplification device further includes a diode (27) having its anode coupled to the bias control input (9') of the respective amplifier (7') of one of said amplification stages, and its cathode coupled to ground (31); a capacitor (35) connected in series with the diode and ground; and an adder device (200, 300) arranged to sum, in use, a respective bias control signal received at the bias control input (9') of said respective amplifier (7') with a diode signal derived from the cathode of said diode, to produce a second output signal that is indicative of the power of the first output signal.

2. An amplification device as claimed in Claim 1, further including a network of one or more resistors (33), the network being connected in series between the diode and ground, the diode signal being provided from a connection point between the diode and the resistor network.

3. An amplification device as claimed in Claim 2, further including a network of one or more resistors (33), the network being connected in series between the diode and ground, the diode signal being provided from a connection point between the resistor network and ground.

4. An amplification device as claimed in any preceding claim, wherein a second capacitor (37) is included in series between the anode of the diode and the bias control input.

5. An amplification device as claimed in any preceding claim, included in an Integrated Circuit (IC) comprising an output terminal for providing said second output signal.

6. An amplification device as claimed in any preceding claim, included in an Integrated Circuit (IC) having an output terminal for providing a third output signal comprising said diode signal.

7. An amplification device as claimed in any preceding claim wherein the amplification device comprises a plurality of amplification stages and the second output signal is derived from the bias control input of the amplifier of an intermediate amplification stage.

8. An amplification device as claimed in any preceding claim wherein each amplifier comprises a bipolar transistor and the bias control input comprises the base input of the transistor.

9. A gain controlled amplifying apparatus (5) comprising an amplification device as claimed in Claim 1; a gain controller (11) for adjusting the gain of the amplification device by means of a gain control signal, the gain controller being arranged to receive said second output signal, to compare the detected power signal with a reference signal and to produce the gain control signal, the level of which gain control signal depends on the difference between the second output signal and the reference signal.

10. A method of measuring the output power of an amplification device (5) as claimed in Claim 1, the method comprising summing a respective bias control signal received at the bias control input of said respective amplifier with a diode signal derived from the cathode of said diode to produce a second output signal that is indicative of the power of the first output signal.

## Patentansprüche

1. Verstärkungsgerät (5), das so gestaltet ist, dass es ein Eingangssignal empfängt und das empfangene Eingangssignal verstärkt, um ein erstes Ausgangssignal zu erzeugen, wobei das Verstärkungsgerät wenigstens zwei Verstärkungsstufen umfasst, wobei jede Verstärkungsstufe einen jeweiligen Verstärker (7, 7', 7") mit einem jeweiligen Vorspannungssteuereingang (9, 9', 9") aufweist, **dadurch gekennzeichnet, dass** das Verstärkungsgerät ferner eine Diode (27) aufweist, deren Anode mit dem Vorspannungssteuereingang (9') des jeweiligen Verstärkers (7') von einer der genannten Verstärkungsstufen und deren Kathode mit Masse (31) gekoppelt ist; einen Kondensator (35), der in Reihe mit der Diode und Masse geschaltet ist; und ein Addiergerät (200, 300) mit der Aufgabe, beim Gebrauch ein jeweiliges Vorspannungssteuersignal, das am Vorspannungssteuereingang (9') des genannten jeweiligen Verstärkers (7') empfangen wird, mit einem von der Kathode der genannten Diode abgeleiteten Diodensignal zu addieren, um ein zweites Ausgangssignal zu erzeugen, das die Leistung des ersten Ausgangssignals anzeigt.

2. Verstärkungsgerät nach Anspruch 1, das ferner ein Netzwerk von ein oder mehreren Widerständen (33) beinhaltet, wobei das Netzwerk in Reihe zwischen der Diode und Masse geschaltet ist, wobei das Diodensignal von einem Verbindungspunkt zwischen der Diode und dem Widerstandsnetz angelegt wird.

3. Verstärkungsgerät nach Anspruch 2, das ferner ein Netzwerk von ein oder mehreren Widerständen (33) beinhaltet, wobei das Netzwerk in Reihe zwischen der Diode und Masse geschaltet ist, wobei das Diodensignal von einem Verbindungspunkt zwischen dem Widerstandsnetz und Masse angelegt wird.

4. Verstärkungsgerät nach einem der vorherigen Ansprüche, wobei ein zweiter Kondensator (37) in Reihe zwischen der Anode der Diode und dem Vorspannungssteuereingang geschaltet ist.

5. Verstärkungsgerät nach einem der vorherigen Ansprüche, das in einer integrierten Schaltung (IC) enthalten ist, die einen Ausgangsanschluss zum Bereitstellen des genannten zweiten Ausgangssignals umfasst.

6. Verstärkungsgerät nach einem der vorherigen Ansprüche, das in einer integrierten Schaltung (IC) enthalten ist, die einen Ausgangsanschluss zum Bereitstellen eines dritten Ausgangssignals hat, das das genannte Diodensignal umfasst.

7. Verstärkungsgerät nach einem der vorherigen Ansprüche, wobei das Verstärkungsgerät mehrere Verstärkungsstufen umfasst und das zweite Ausgangssignal vom Vorspannungssteuereingang des Verstärkers einer Zwischenverstärkungsstufe abgeleitet ist.

8. Verstärkungsgerät nach einem der vorherigen Ansprüche, wobei jeder Verstärker einen bipolaren Transistor umfasst und der Vorspannungssteuereingang den Basiseingang des Transistors umfasst.

9. Geregelte Verstärkungsvorrichtung (5), umfassend ein Verstärkungsgerät nach Anspruch 1; einen Verstärkungsregler (11) zum Justieren des Verstärkungsfaktors des Verstärkungsgerätes mittels eines Verstärkungsregelungssignals, wobei der Verstärkungsregler die Aufgabe hat, das genannte zweite Ausgangssignal zu empfangen, um das erfasste Leistungssignal mit einem Referenzsignal zu vergleichen und das Verstärkungsregelungssignal zu erzeugen, dessen Pegel von der Differenz zwischen dem zweiten Ausgangssignal und dem Referenzsignal abhängt.

10. Verfahren zum Messen der Ausgangsleistung eines Verstärkungsgerätes (5) nach Anspruch 1, wobei das Verfahren das Addieren eines jeweiligen Vorspannungssteuersignals, das am Vorspannungssteuereingang des genannten jeweiligen Verstärkers empfangen wird, mit einem Diodensignal beinhaltet, das von der Kathode der genannten Diode abgeleitet wird, um ein zweites Ausgangssignal zu erzeugen, das die Leistung des ersten Ausgangssignals anzeigt.

## Revendications

1. Dispositif d'amplification (5) agencé pour recevoir un signal d'entrée et amplifier le signal d'entrée reçu afin de produire un premier signal de sortie, le dispositif d'amplification comprenant au moins deux étages d'amplification, chaque étage d'amplification comportant un amplificateur respectif (7, 7', 7") ayant une entrée de commande de polarisation respective (9, 9', 9"), **caractérisé en ce que** le dispositif d'amplification comporte en outre une diode (27) dont l'anode est couplée à l'entrée de commande de polarisation (9') de l'amplificateur respectif (7') de l'un desdits étages d'amplification, et la cathode est couplée à la masse (31) ; un condensateur (35) connecté en série avec la diode et la masse ; et un dispositif additionneur (200, 300) agencé pour additionner, durant l'utilisation, un signal de commande de polarisation respectif reçu au niveau de l'entrée de commande de polarisation (9') dudit amplificateur respectif (7') avec un signal de diode dérivé de la cathode de ladite diode, afin de produire un deuxième signal de sortie qui est indicatif de la puissance du premier signal de sortie.

2. Dispositif d'amplification selon la revendication 1, comportant en outre un réseau d'une ou de plusieurs résistances (33), le réseau étant connecté en série entre la diode et la masse, le signal de diode étant fourni depuis un point de connexion entre la diode et le réseau de résistances.

3. Dispositif d'amplification selon la revendication 2, comportant en outre un réseau d'une ou de plusieurs résistances (33), le réseau étant connecté en série entre la diode et la masse, le signal de diode étant fourni depuis un point de connexion entre le réseau de résistances et la masse.

4. Dispositif d'amplification selon l'une quelconque des revendications précédentes, dans lequel un deuxième condensateur (37) est inclus en série entre l'anode de la diode et l'entrée de commande de polarisation.

5. Dispositif d'amplification selon l'une quelconque des revendications précédentes, inclus dans un Circuit Intégré (CI) comprenant une borne de sortie pour fournir ledit deuxième signal de sortie.

6. Dispositif d'amplification selon l'une quelconque des revendications précédentes, inclus dans un Circuit Intégré (CI) comprenant une borne de sortie pour fournir un troisième signal de sortie comprenant ledit signal de diode.

7. Dispositif d'amplification selon l'une quelconque des revendications précédentes, dans lequel le dispositif d'amplification comprend une pluralité d'étages d'amplification et le deuxième signal de sortie est dérivé de l'entrée de commande de polarisation de l'amplificateur d'un étage d'amplification intermédiaire.

8. Dispositif d'amplification selon l'une quelconque des revendications précédentes, dans lequel chaque amplificateur comprend un transistor bipolaire et l'entrée de commande de polarisation comprend l'entrée de base du transistor.

9. Appareil d'amplification à gain commandé (5) comprenant un dispositif d'amplification selon la revendication 1 ; une unité de commande de gain (11) pour régler le gain du dispositif d'amplification au moyen d'un signal de commande de gain, l'unité de commande de gain étant agencé pour recevoir ledit deuxième signal de sortie, afin de comparer le signal de puissance détecté à un signal de référence et produire le signal de commande de gain, le niveau dudit signal de commande de gain dépendant de la différence entre le deuxième signal de sortie et le signal de référence.

10. Procédé de mesure de la puissance de sortie d'un dispositif d'amplification (5) selon la revendication 1, le procédé comprenant la sommation d'un signal de commande de polarisation respectif reçu au niveau de l'entrée de commande de polarisation dudit amplificateur respectif avec un signal de diode dérivé de la cathode de ladite diode afin de produire un deuxième signal de sortie qui est indicatif de la puissance du premier signal de sortie.
